Europäisches Patentamt

European Patent Office

Office européen des brevets

(11) Publication number: **0 135 676**
A2

## EUROPEAN PATENT APPLICATION

(21) Application number: **84107151.7**

(22) Date of filing: **22.06.84**

(51) Int. Cl.⁴: **C 30 B 25/14**, C 30 B 25/20

(30) Priority: **30.06.83 US 509756**
**30.06.83 US 509511**

(43) Date of publication of application: **03.04.85**
**Bulletin 85/14**

(84) Designated Contracting States: **DE FR GB**

(71) Applicant: **International Business Machines Corporation, Old Orchard Road, Armonk, N.Y. 10504 (US)**

(72) Inventor: **Murgai, Ashok, Innsbruck Boulevard, Hopewell Junction New York 12533 (US)**
Inventor: **Kim, Kyong-Min, Mountain Pass Road, Hopewell Junction New York 12533 (US)**
Inventor: **Smetana, Pavel, 37 Hillis Terr., Poughkeepsie New York (US)**
Inventor: **Schwuttke, Guenther H., 8162 East Del Pico Drive, Scottsdale Arizona 85258 (US)**

(74) Representative: **Oechssler, Dietrich, Dr. rer. nat., Schönaicher Strasse 220, D-7030 Böblingen (DE)**

(54) **Apparatus for growing Czochralski crystals and growth method using such apparatus.**

(57) The apparatus comprises a stationary crucible (32), a heater (38) surrounding said crucible (32), a rotating susceptor (40) and means for introducing a seed crystal (26) into the molten source (12) and withdrawing it with the growing crystal (82, 10). In its one embodiment the suceptor (40) of the apparatus comprises conductive inner and outer layers (58, 60) with said inner layer (58) consisting of a material having a thermal diffusivity lower than that of said outer layer (60). In its other embodiment the apparatus contains means for simultaneously applying a magnetic field to the molten source.

The apparatus is used for growing crystals with the Czochralski technique. During the growth the susceptor (40) but not the crucible (32) rotates and — if said one embodiment is used — a magnetic field is applied to the molten source.

The apparatus and method serve to eliminate thermal asymmetry in the melt.

## APPARATUS FOR GROWING CZOCHRALSKI CRYSTALS AND GROWTH METHOD USING SUCH APPARATUS

The invention relates to an apparatus for growing Czochralski crystals having a central stationary crucible adapted to contain the source of materials for the crystal to be grown, a heater concentrically surrounding said central crucible and operative to render and maintain the source material in a molten state, means for introducing a seed crystal into the molten source material and withdrawing it at a controlled rate as the source material crystallizes thereupon axially of said crucible, and a susceptor concentrically interposed between said heater and said crucible and rotating around the axis of the crucible, and a method for growing crystals by Czochralski technique using such an apparatus, where source material for the crystal is confined within said crucible, said heater concentrically surrounding said crucible is energized to effect and maintain said source material in a molten state, said cylindrical susceptor concentrically interposed between said heater and said crucible is rotated and said seed crystal is introduced into the molten source material and then withdrawn at a controlled rate.

The Czochralski method of growing single crystals of semiconductor materials is the most commonly used, wherein a melt of hyperpure silicon or the like from which a single crystal is to be grown is effected within a quartz-lined graphite crucible. The crucible and its charge, which may include a doping impurity are normally placed within an enclosure and under a controlled, inert atmosphere, a heater coil which encircles the crucible and supplies heat to melt the

FI 982 055/056

charge. The temperature of the melt is maintained just above the melting point of the charge, and a seed crystal, which may be a small highly perfect and oriented crystal of silicon, is dipped into the molten silicon. The seed partially melts to remove surface imperfections and the seed is then very slowly withdrawn from the melt. The seed is normally positioned axially of the upwardly open crucible and withdrawn slowly. In most cases, seed pull rate and temperature are varied to achieve a dislocation-free single crystal growth.

Uniform and homogeneous solute (dopant/impurity) distribution on the micro-scale in silicon crystals is of primary importance for VLSI device applications. However, silicon crystals grown from the melt by the variations in the Czochralski technique as used to date in VLSI applications, are not completely homogeneous.

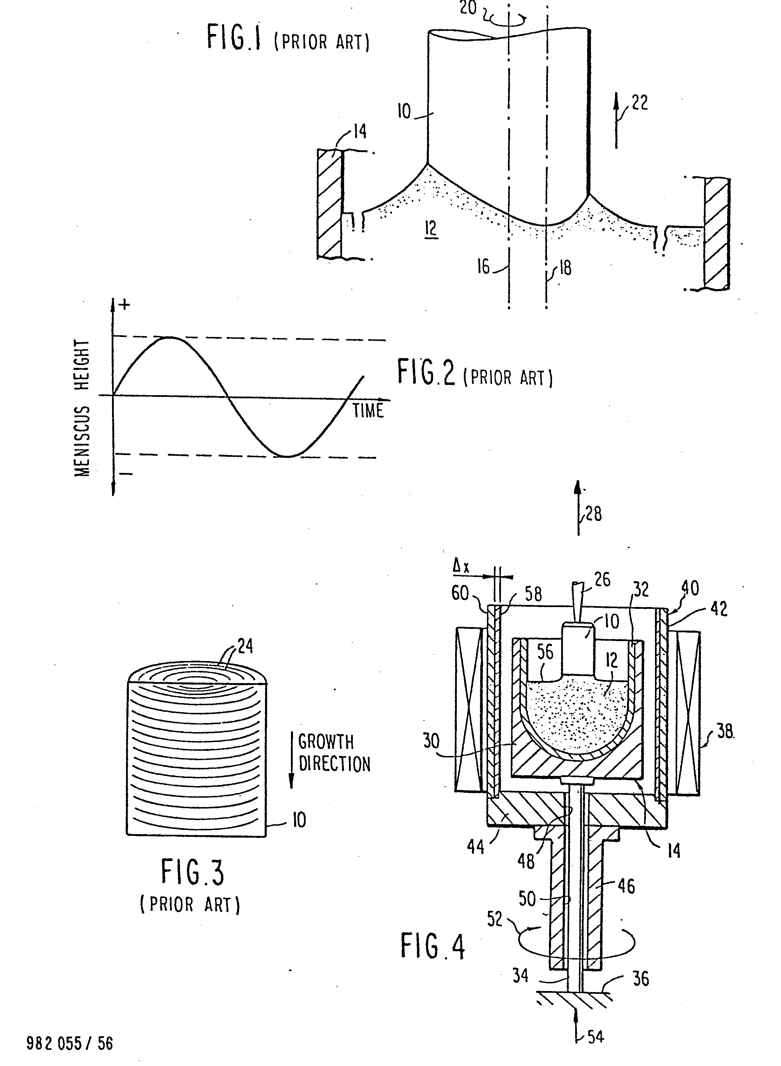

In a practical crystal growth configuration, the presence of misalignment of the geometric and thermal axes is unavoidable. This results in regions of the crucible closer to the heater being hotter than regions away from the heater and an asymmetric crystal-melt interface results as shown. Rotation of the crystal, as per arrow 20 then results in the crystal alternately passing through hotter and cooler regions of melt and in corresponding variations in the microscopic growth rate as seen in Figure 2. These, in turn, affect the concentration of impurity (such as dopant, oxygen, etc.) incorporated in the crystal. A banded distribution of the impurities results along the growth direction, Figure 3. On the cross-sectional slice, these appear as concentric rings of variation of impurity concentration, as at 24. When the crucible is also rotated, some of the above thermal asymmetry is reduced due to the associated homogenization in thermal gradients. However, two other kinds of compositional fluctuations are then grown into the crystals. One is associated with rotation of a non-intermixing cell of fluid flow called the Taylor-Poundman column which develops under the crystal. The other type is associated with thermal convection and also its interaction with the force of gravity.

Other efforts to improve the quality of the crystals grown under the Czochralski technique include the application of magnetic fields to the melt, and various attempts have been made to render uniform the heat application to and the temperature of the melt within the crucible.

The physical phenomena causing non-uniformity of the dopant/impurity in the conventional CZ silicon crystals caused during crystal growth, can be summarized as follows:

(1)    Thermal convection in the melt;

(2)    Marangoni flow due to the surface tension gradient on the melt surface;

(3)    Force convection in the melt due to the rotation of crystal and/or crucible;

(4)    Rotation of the crystal and/or crucible in the presence of rotational non-symmetry of the temperature distribution in the melt; and

FI 982 055/056

(5)  Non-constant crystal pull rate.

Homogeneous CZ silicon crystal growth can be achieved only if the phenomena listed above are eliminated or substantially reduced.

All the rotation associated compositional fluctuations can be eliminated by stopping the crystal and crucible rotation. However, when this is done, the crystal, as it grows, will try to relocate itself so that the geometric and thermal axes as at 16, 18, Figure 1, are aligned. Hence, the crystal will grow banana-shaped which is highly undesirable. Furthermore, the presence of thermal asymmetry will result in icing of the melt and thereby interfere with growth.

U.S. patent 3,551,115 to J. E. Jamieson and Thomas H. Strudwick, issued December 29, 1970, assigned to the common assignee, suggest that the thermal asymmetry may be minimized under RF induction heating by employing a rotating annular graphite (or other electrically conductive refractory material) cylinder around the crucible, interposed concentrically between the RF induction heating oil and the crucible.

Witt et al in the Journal of Materals Science, Volume 5, pages 822-824 (1970), describes a process, wherein a transverse magnetic field is applied through the melt in a conventional CZ crystal growth of a low melting point semiconductor InSb. Hoshi et al in Abstract No. 324, pp. 811-813, The Electrochemical Society Extended Abstracts, St. Louis, Missouri, May 11-16, 1980, apply a transverse magnetic field in the CZ silicon crystal growth. In both cases, fluid flow instabilities or convections in the melt are eliminated. But the rotational thermal symmetry is not established in the conventional CZ crystal growth, and the asymmetry becomes even worse under the applied magnetic field. Therefore, rotation of the crystal and/or crucible has seemed a necessity to grow crystals of a circular cross-section in the magnetic field CZ crystal growth. This, in turn, results in the heterogeneous incorporation of dopants and impurities, so-called rotational striations, which defeats the purpose of suppressing the convection in the melt by applying the magnetic field for the production of homogeneous crystals.

Kim et al in IBM Technical Disclosure Bulletin, Volume 24, No. 7A, pp. 3376-3377 (1981), apply an axial magnetic field in the CZ silicon crystal growth to suppress convections in the melt. Kim in the Journal of the Electrochemical Society, Volume 129, pp. 427-429, investigates systematically the effect of a transverse magnetic field on the suppression of thermal convections in the semiconductor crystal growth from the melt.

While these measures have been partially effective in obtaining uniformity of the dopant/impurity in conventional CZ silicon crystals, they have not been sufficiently effective to reach the degree of homogeneity required for current crystal use.

It is the object of the invention to provide an apparatus and a method to improve the growth of Czochralski crystals with regard to thermal symmetry in the melt leading to the reduction of segregation band density and the elimination of striations and heterogeneities in the grown crystal.

This object is achieved by apparatus as defined at the beginning of this specification having the features of the characterizing part of claims 1 and 5 and by a method as defined at the beginning of this specification having the feature of the characterizing part of claim 10.

In applying the modifications of the Czochralski technique according to the invention the attenuation of thermal inhomogeneities in the melt functioning as the crystal growing material is maximized and the structural dimensions and the process parameters are optimized for significantly greater homogenization of the radial thermal asymmetry of the crystal-melt interface.

In the one embodiment of the inventive apparatus the susceptor has thermal conductive inner and outer layers, with the inner layer consisting of a material whose thermal diffusivity is lower than that of the outer layer. The inner layer materially reduces the temperature variations in the melt.

In the other embodiment of the inventive apparatus and using the inventive method, thermal convection and Marangoni flow in the melt is suppressed by applying a magnetic field across the melt. On the other hand, rotational thermal symmetry is achieved by rotating a thermal trimmer (RTT) susceptor without there being any necessity of rotating the crucible. Crystal rotation is reduced to a minimum rate approaching zero rpm, and the crystal is pulled with a constant pull rate, but without rotation thereof. The crystal diameter is controlled by the heat input to the growth system.

FI 982 055/056

The simultaneous achievements of fluid flow suppression and rotational thermal symmetry, as will be described hereinafter, alleviate all of the adverse influences listed as parameters resulting in non-uniformity of the dopant/impurity in conventional CZ silicon crystals, and it is possible to grow homogeneous CZ silicon crystals under a diffusion-controlled steady state mass-transport at the solid-liquid growth interface. Such growth conditions are ideal in achieving uniform distribution of dopant/impurities in the crystal. Previously, such conditions were impossible of realization in CZ silicon crystal growth.

Advantageous embodiments of the invention are disclosed in the subclaims.

The invention will become more apparent from the following detailed description taken in conjunction with the accompanying drawing.

Figure 1        is a schematic elevational view in section of the crystal melt interface in a typical prior art Czochralski crystal growing system.

Figure 2        is a plot showing the fluctuation in meniscous height under the conditions illustrated in Figure 1 during crystal growing by use of the prior art technique.

Figure 3        is a perspective view of a single crystal grown by the technique employed in Figure 1, illustrating, in transverse and axial sections at right angles to and along the growth direction of the crystal, the banded distribution of impurities.

Figure 4    is a schematic vertical sectional view of an embodiment of the improved apparatus for achieving homogenization of radial thermal gradients in CZ crystal growth from a non-rotated melt forming a preferred embodiment of the present invention with optimization of both the process parameters and the dimensional relationship of the components forming said apparatus.

Figure 5    is a schematic side elevation, partially in section, of a CZ silicon crystal growth apparatus forming another preferred embodiment of the present invention, employing a rotating thermal trimmer and a coaxial magnetic field.

Figure 6    is a schematic, top plan view of an alternate form of the CZ silicon crystal growth apparatus shown in Figure 5 which employs a transverse magnetic field and a rotating thermal trimmer.

Figure 7    is a photomicrograph of a longitudinal crystal section after chemical etching which delineates the dopant non-uniformity of striations in a conventionally grown CZ crystal.

| Figure 8 | is a photomicrograph of a longitudinal crystal section after chemical etching of a CZ crystal produced in accordance with the present invention, showing the absence of dopant striations. |

| Figure 9 | is a plot of the longitudinal resistivity profile of the crystal section of Figure 7. |

| Figure 10 | is a plot of the longitudinal resistivity profile of the crystal section shown of Figure 8. |

Referring to Figure 4, this figure represents schematically a generic type of commercially available crystal growing apparatus adapted to grow crystals by the Czochralski technique, and modified according to the one embodiment of the inventive apparatus.

As in Figure 1, the crystal 10 is pulled from the melt 12 by a mechanism schematically represented by pull rod 26 for crystal 10 which is capable of raising the crystal at a given linear velocity $V_1$ by means (not shown) and with that velocity represented by arrow 28. The melt 12 is contained in a crucible indicated generally at 14 and comprised of a crucible holder or body 30 which may be formed of graphite or the like of cylindrical form bearing a quartz liner 32 which is cup-shaped and upwardly open. The crucible 14 is non-rotating and is fixedly mounted to the top of a non-rotating pedestal 34, the pedestal being fixed at its bottom to base 36.

The crucible 14 is heated by means of a coil of cylindrical form indicated generally at 38, supplied by a current source (not shown). Interposed concentrically between the central crucible 14 and the concentric coil 38 is a rotating thermal trimmer susceptor assembly indicated generally at 40. The thermal trimmer susceptor assembly 40 is located and is sized such that it has a few millimeters clearance between crucible 14 on the one side and the coil 38 on the other. Susceptor assembly 40 is constituted principally by a cylindrical susceptor body 42 having an inside diameter greater than that of crucible 14 and being fixedly mounted coaxial with the crucible 14 on a circular plate 44. The plate 44 spans beneath the crucible 14 and the plate 44 is fixedly mounted to a rotating tubular pedestal 46. The plate 44 is provided with a circular hole 48 through which passes the non-rotating pedestal 34, the pedestal 34 also passing through axial bore 50 of the rotating tubular pedestal 46. The thermal trimmer susceptor assembly 40 is rotated about its axis as indicated by arrow 52 at an angular velocity $W_1$ (rpm) by means (not shown). Such means and the details of the crystal drawing apparatus may be similar to that provided within U.S. patent 3,551,115, assigned to the common assignee. With the rotating tubular pedestal 46 and the non-rotating pedestal 34 being positioned on a common base 36, their vertical translation may be achieved by vertically raising and lowering base 36, as indicated by double headed arrow 54 by means (not shown).

In accordance with conventional practice, silicon crystal 10 is pulled from the melt 12 at the melt level or interface 56, this being achieved conventionally by the utilization of a seed crystal fastened to pull rod 26 and with the pull rod slowly raised as indicated by arrow 28 in a direction away from melt 12 and axially from the center of the crucible. Again, the mechanism for achieving that end may be of the type as set forth in U.S. patent 3,551,115.

Heat is applied by energization of the RF induction coil or heater 38 and the thermal trimmer susceptor assembly 40 is rotated about its axis as indicated by arrow 52. As the silicon crystal 10 is withdrawn from the melt 12, the crucible 14 is raised vertically as per arrow 54 at a rate such that the surface level or interface 56 of the melt 12 is constant relative to the heater 38. Important to the present invention, neither crystal 10 nor crucible 14 is rotated during the process. In part, the present invention is directed to the make up of the rotating thermal trimmer susceptor body 42. It has been determined that a significant reduction in the temperature variation in the melt by fabricating the rotating thermal trimmer susceptor cylinder body 42 of markedly lower thermal diffusivity than that of graphite, previously employed by Kim et al as described in the Background of the Invention hereinabove. This is true for other thermally conductive materials which may or could be employed for the thermal trimmer susceptor. Such low thermal diffusivity, electrically non-conductive material, of which silica is exemplary, insures high thermal homogeneity within the melt and can withstand temperatures up to 1800°C, thus making it suitable for silicon crystal growth to which the invention has primary application.

For comparison, the thermal diffusivities $\kappa$ of silica and graphite are as follows:

FI 982 055/056

$$\kappa \text{ silica} \quad = \frac{k}{c/\rho} = 0.003/(0.24 \times 227) = 0.006 \text{ cm}^2/\text{s}$$

$$\kappa \text{ graphite} = \frac{k}{c/\rho} = 0.38/(0.17 \times 2) = 1 \text{ cm}^2/\text{s}$$

where:

k is the thermal conductivity,

c is the specific heat, and

$\rho$ is the density of silica and graphite,

respectively.

As shown in Figure 4, the rotating thermal trimmer susceptor cylindrical body 42 is not completely silica. In this case, a silica liner 58 is supported and housed inside an outer graphite cylinder 60 of the same length, since silica normally softens around the silicon crystal growth temperatures.

It has been additionally ascertained that the thickness $\Delta x$ (cm) of the silica cylinder 58 is a critical parameter for the successful operation of the crystal pulling apparatus to maximize the reduction in temperature variations in the melt 12. The thickness $\Delta x$ is dependent upon the rotation rate R (rps) for the rotating thermal trimmer susceptor assembly 40 to be employed for (1-N) fractional attenuation of temperature variation permitted within melt 12. $\Delta x$ is then defined by the relationship:

$$\Delta x = \sqrt{\frac{\kappa}{\pi R}} \cdot \ln (N) \tag{1}$$

with N being $\frac{100-A}{A}$, where A is the attenuation of the temperature value variations in percent.

FI 982 055/056

For 90 percent attenuation of the temperature value variations in the melt, i.e. N = 0.1, the values of $\Delta x$ are shown below in Table I for silica and for graphite annular cylinders employed alone at various rotation rates from 7.5 to 30 rpm:

### TABLE I

| r = 60 · R (rpm) | $\Delta X$ = Silica (cm) | $\Delta X$ = Graphite (cm) |
|---|---|---|
| 7.5 | 0.28 | 3.68 |
| 15.0 | 0.2 | 2.59 |
| 30.0 | 0.15 | 1.83 |

As may be seen from the above table by employing an annular cylinder of graphite, the result is unwieldy values for thickness. Thus, even at 30 rpm rotation of the susceptor cylinder 42, the thickness required for graphite would be 1.83 x 2 $\geq$ 3.56 cm across the diameter, and this cylinder would take up too much space within the crystal pulling apparatus. On the other hand, a thickness only 0.15 x 2 $\geq$ 0.3 cm, would be required across a diameter for a silica susceptor body.

Additionally, from the relationship (1) above, it may be readily seen that for the parameters employed by Kim et al, referred to in the Background of the Invention hereinabove, the attenuation with graphite alone is only $\sim$ 15 per cent.

In arriving at optimum process parameters, it should be noted that consideration must be given to the time lag resulting between the time when the maximum temperature variation is realized inside the susceptor cylinder 42 versus the time when the temperature variation is realized outside this cylinder. It is particularly important for considering quasi-steady state temperature changes made in the heater 38 in order to control the diameter of crystal 10 and the oxygen concentration in the crystal. The time lag t is expressed by the following relation:

$$t = \frac{\Delta x^2}{4\kappa N} \qquad (2)$$

Computations with (2) for graphite indicate that the time lags are too large for the thicknesses found in Table I. These time lags appear below:

TABLE II

| r (rpm) | Graphite $\Delta X$ (cm) | t (sec.) |
|---|---|---|
| 7.5 | 3.68 | 103.9 |
| 15.0 | 2.59 | 51.8 |
| 30.0 | 1.83 | 26.0 |

In comparison, using silica as the susceptor cylinder material, one obtains highly reasonable thicknesses and time lags as follows:

TABLE III

| Attenuation (%) | Silica $\Delta X$ (cm) | t (sec.) |
|---|---|---|
| 93.5 | 0.16 | 30 |
| 74.6 | 0.08 | 15 |

FI 982 055/056

- 15 -

Experimental verification of the above relationships is evidenced from the fact that when melt "icing" occurs in a stationary crucible during silicon crystal growth, the "icing" can be made to disappear (i.e. melts back) for sustained periods of time by simply rotating the crucible. The melt in this case is contained in a silica liner supported by a graphite crucible.

From the above, it is apparent that in terms of preferred dimensions and operating parameters for the rotating thermal trimmer susceptor body 42, a 0.16 cm silica cylinder 58 housed inside a 0.32 cm thick graphite cylinder 60 with the assembly rotated at 30 rpm, results in a 93.5 % attenuation of temperature variation in comparison with less than 15 % attenuation from a pure graphite cylinder forming the rotating thermal trimmer susceptor body 42. Thus, the invention provides a range of processing parameters for optimization of crystal growth conditions which, in conjunction with eliminating rotation of the crucible and the melt and pulling of the crystal 10 without rotation of the same, whose end result is minimization of the compositional fluctuation in the crystal 10 produced thereby.

It is difficult to obtain and maintain concentricity of the heater with respect to the crucible. If there is a slight eccentricity of the heater relative to the crucible, the apparatus of the present invention will inherently overcome that problem due to the utilization of the low thermal diffusivity material as the susceptor or as the inner layer of a dual layer susceptor. A variation in the rotation rate of the susceptor stands required to insure minimizing temperature variation within the melt. One may determine from the algorithm the proper rotation rate of the susceptor to achieve that end.

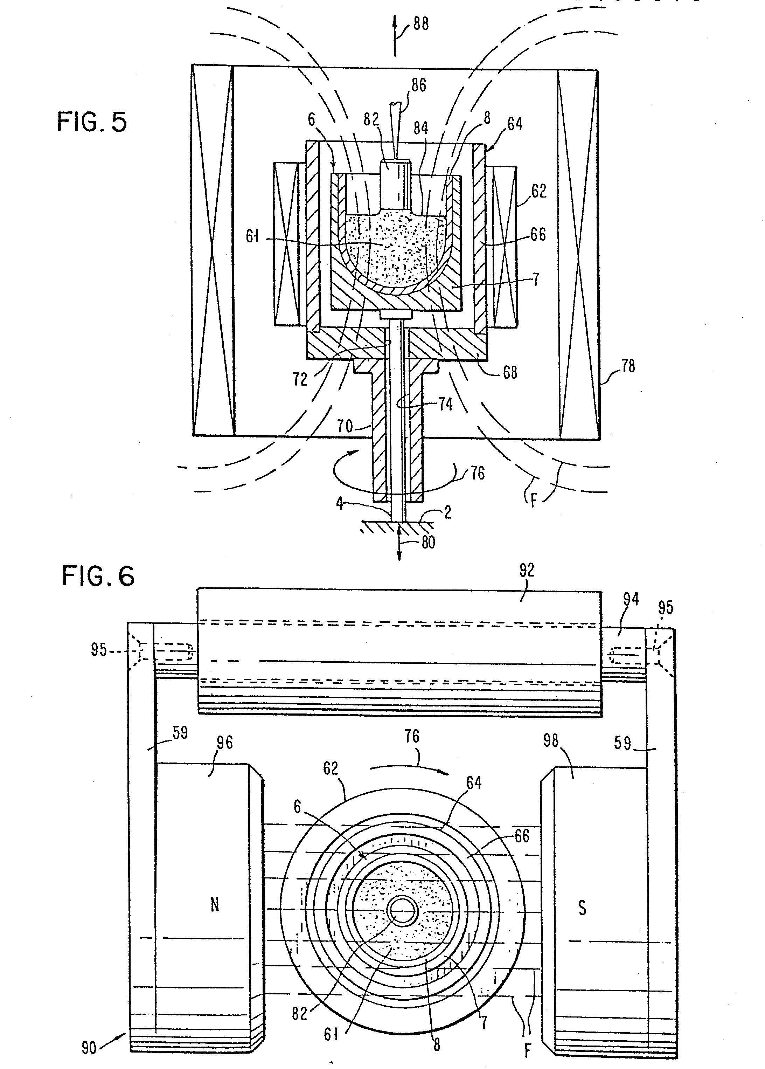

In the following the other embodiment of the inventive apparatus employing a rotating thermal trimmer or susceptor in conjunction with the application of an axial or transverse magnetic field, and the inventive method using said other embodiment of the inventive apparatus are described with reference to Figures 5 to 10.

In Figures 5 and 6, like numerals are employed for like elements.

Turning to Figure 5, in the schematic, vertical sectional view, the apparatus forming one of two preferred embodiments of the present invention includes a base member 2 from which projects upwardly a non-rotating pedestal 4. At the top of pedestal 4, there is mounted a non-rotating crucible 6 of cylindrical form which comprises a graphite crucible holder body or the like 7 containing a quartz liner 8 which contains a melt 61 of hyper pure silicon or the like. The quartz liner 8 is cup-shaped and is upwardly open. The crucible 6 is heated by means of an RF induction coil of cylindrical form as at 62 supplied by an RF current by means (not shown). Interposed concentrically between the central crucible 6 and the concentric induction coil 62 is a rotating thermal trimmer susceptor assembly indicated generally at 64. The thermal trimmer susceptor assembly 64 is located and is sized such that it has a few milimeters clearance between crucible 6 on the one side and the RF induction coil 62, or the other side.

The thermal trimmer susceptor assembly 64, which is of cylindrical form, includes a cylindrical susceptor body 66, which may be formed of an electrically conductive refractory material such as graphite, is fixedly mounted to a circular plate 68 and projects upwardly therefrom. Plate 68 spans beneath the crucible 6 and is fixedly mounted to a rotating tubular pedestal 70. The plate 68 is provided with a circular hole 72 which is of a diameter in excess of the non-rotating pedestal 4, passing therethrough and similarly the rotating tubular pedestal 70 has a bore 74 equally sized and also receiving the non-rotating pedestal. The rotating thermal trimmer susceptor assembly 64 rotates coaxially about the pedestal 4 axis, as indicated by arrow 76 by means (not shown). Such means may be similar to that provided within U.S. patent 3,551,115, assigned to the common corporate assignee.

As an important aspect of the present invention, a solenoid DC electromagnet 78 is positioned concentrically about the RF induction coil a heater 62 and preferably extends the full height of the crucible 6. The solenoid electromagnet 78 is supplied with a DC current from a source (not shown) such that a magnetic field F is set up axially or longitudinally through the melt 61.

The rotating tubular pedestal 70 and the non-rotating pedestal 4, positioned on a common base 2 have their vertical translation achieved by vertically raising and lowering base 2, as indicated by the double headed arrow 80. In accordance with conventional practice, a silicon crystal as at 82 is pulled from the melt 61 at the interface 84, this being achieved conventionally by the utilization of a seed crystal which is fastened to pull rod 86, with the pull rod slowly raised as indicated by arrow 88 in a direction away from the melt

61. The crystal 82 is pulled axially from the center of the crucible. The mechanism for achieving that end may be of the type set forth in U.S. patent 3,551,115, referred to previously.

Electromagnet 78 functions to provide a magnetic field F through the melt above a critical field strength which may be about 1-4 K gauss, in order to suppress thermal convection and other fluid flow instability for melt 61.

In operation with respect to the apparatus of Figure 1, an axial magnetic field F is applied through the melt 61 by energization of the electromagnet 78. Simultaneously, heat is applied by energization of the RF coil 62 and the thermal trimmer susceptor assembly 64 is rotated about its axis as indicated by arrow 76. The silicon crystal 82 is withdrawn from the melt 61. Conventionally, the graphite crucible holder body 7, which supports the crucible liner 8 and the silicon melt 61, is raised vertically as per arrow 88 at a rate such that the surface level 84 of the melt 61 is constant relative to the RF heater 62. Importantly, neither crystal 82 nor crucible 6 is rotated. By the method of the present invention, one may readily produce silicon single crystals of 100 mm or larger in diameter at a pull rate similar to those of conventional CZ crystal growth.

Referring next to Figure 6, the schematic top plan view illustrates the structural components of a modified form of apparatus for uniform homogeneous CZ silicon crystal pulling, within which is positioned the silicon melt 61. This view illustrates the crystal 82, which is being pulled upwardly or out of the base of the drawing, axially centered with the crucible 6 and melt 61. The rotating thermal trimmer susceptor assembly 64 rotates clockwise in accordance with arrow 76 in the same manner as the Figure 5 apparatus. The difference in this modified apparatus is the nature and application of the magnetic field to the melt 61 within crucible 6. As in the Figure 5 apparatus, the crucible 6 is fixed against rotation, although as in said apparatus, it may be raised and lowered as necessary to maintain the melt centered within the heater 62. Closely positioned to the outside of the susceptor body 66 itself is the RF induction coil 62, the crucible 6, the susceptor 64, and the RF induction coil 62 all being concentric.

In this modified apparatus, the difference lies in the nature and application of the magnetic field F to melt 61. Instead of using an H type electromagnet which has been employed in the past to provide a transverse magnetic field during CZ silicon crystal growth, the schematic representation in Figure 6 of the magnetic field assembly indicated generally at 90, comprises a cylindrical, solenoid electromagnet 92 whose internal diameter is slightly larger than the diameter of a cylindrical iron yoke 94 which the electromagnet 92 concentrically surrounds. The cylindrical magnetic iron yoke 94 is of a length which is determined principally by the gap between north and south magnet poles 96 and 98 which form part of assembly 90 and which poles may be of circular, rectangular or square geometry. These magnetic iron members 96, 98 are mounted to faces of iron plates 59. The magnet poles 96 and 98 cover the lateral width of crucible 6. The other ends of the iron plates bridge across the ends of magnetic iron yoke 94, being detachably mounted thereto by screws 95, for instance. The axial length of the cylindrical iron yoke 94 can be varied. This allows to change the magnetic field structure in order to accommodate different sized CZ growth chambers and to remove easily the magnetic field assembly 90 from the CZ growth system facilitating set up and cleaning of the system.

As shown, the silicon melt 61 contained in the silica lined graphite crucible 6 is positioned inside and centered with respect to the two magnetic poles 96 and 98. The gap distance between the poles may be suitably changed by increasing or decreasing the length of the cylindrical yoke 94 in order to accommodate different sizes of CZ growth chambers and thus different silicon charge sizes for melt 61. In contrast, in the case of a conventional H type magnet normally employed, a completely new magnet is needed for the new growth chamber diameter larger than a specific size given by the magnet. Secondly, the magnet assembly may be easily removed from the CZ growth system by moving the assembly 90 laterally such that the poles 96 and 98 move outwardly and away from the CZ growth system. This permits ease in both setting up and cleaning of the growth system.

In operation, the method of pulling the crystal is identical to that as described with regard to the apparatus of Figure 5. By use of either embodiment, silicon crystals grown under the process parameters are free of striations, while extensive striations or heterogeneities are observed in conventional CZ silicon crystals grown without the application of a magnetic field and in conjunction with rotation of the crystal and/or the crucible.

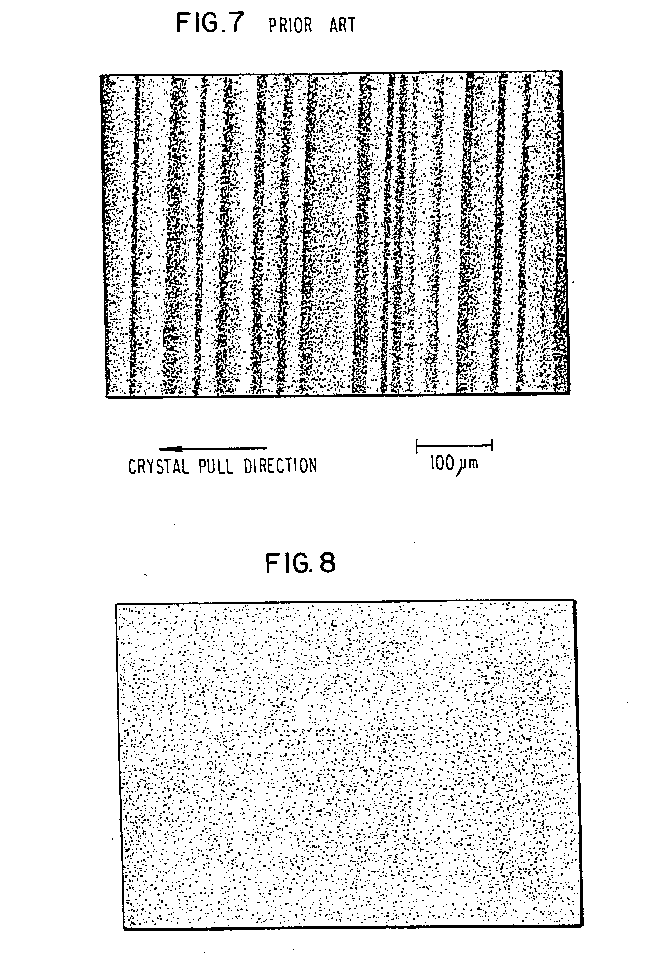

Referring next to Figures 7 and 8, respectively, these photomicrographs are typical longitudinal sections of the latter and former crystals after a chemical preferential etching which constitutes one of the most sensitive means to delineate the dopant/impurity striations. In Figure 7, the striations are quite noticeable and are due to convection in the melt and rotation of the crystals and crucible which, for the sample shown were 15 and 8 rpm, respectively. The contrast is markedly evident. Figure 8 shows a complete absence of striations grown by the method and apparatus of the present invention, where a magnetic field strength of 4 K gauss using an axially aligned electromagnetic coil such as that at 78 in Figure 5, was applied, in conjunction with an 8 rpm rotation of the rotating thermal trimmer susceptor (RTT). The crystal pull rates for both the sample of Figure 7 and the sample of Figure 8 were the same, i.e. 5.0 cm per hour. The crystals were heavily boron-doped to a level of 0.03 ohms-cm for a resolution of the dopant heterogeneity.

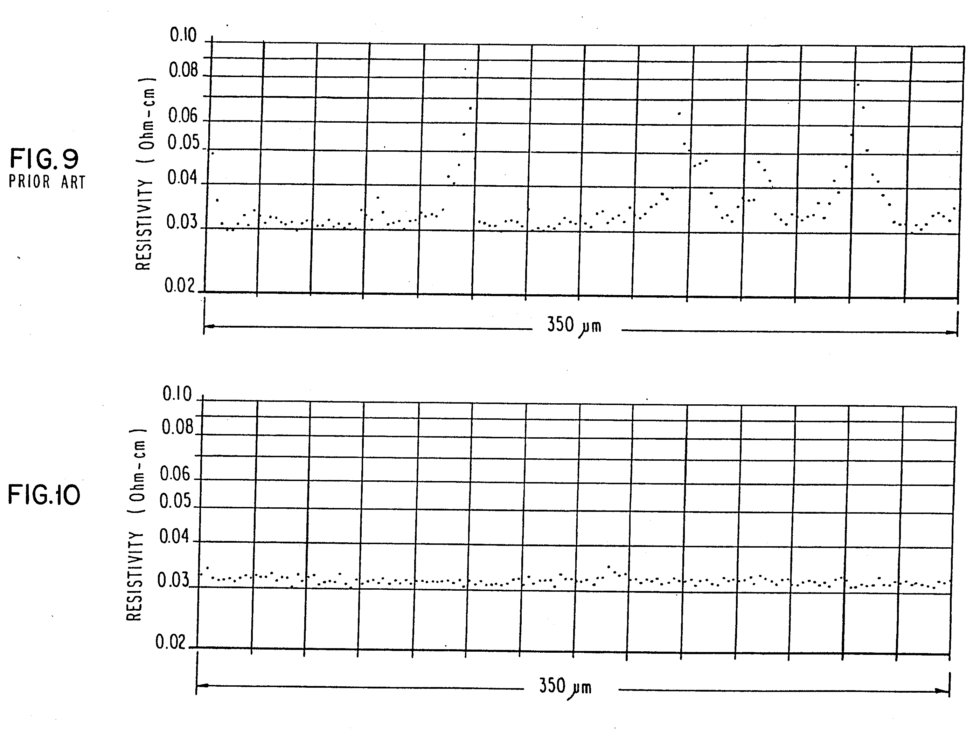

Turning next to Figures 9 and 10, these are respectively the resistivity profiles parallel to the crystal growth axis of the longitudinal sections of a crystal grown by a conventional CZ crystal process and that of the present invention.

In Figure 9, there are large variations in the resistivity exhibited in the crystal grown by the conventional process in comparison to the crystal achieved by the process and apparatus of the present invention.

In Figure 10, the resistivity profile is uniform and these resistivity profiles confirm those of the striation etching study as seen in Figures 7 and 8. The

0135676

resistivity profile on the microscale was measured by means of the spreading resistance techniques using 2.5 μm steps in conjunction with two probes of 35 μm separation.

C L A I M S

1.    Apparatus for growing Czochralski crystals having a central stationary crucible adapted to contain the source of materials for the crystal to be grown,

a heater concentrically surrounding said central crucible and operative to render and maintain the source material in a molten state,

means for introducing a seed crystal into the molten source material and withdrawing it at a controlled rate as the source material crystallizes thereupon axially of said crucible,

and a susceptor concentrically interposed between said heater and said crucible and rotating around the axis of the crucible,

characterized in that said susceptor (42) comprises thermal conductive inner and outer layers (58, 60) with said inner layer (58) consisting of a material having a thermal diffusivity lower than that of said outer layer (60).

2.    Apparatus as claimed in claim 1, wherein said outer layer (60) is graphite and said inner layer (58) is silica.

3.    Apparatus as claimed in claim 1, wherein the thickness $\Delta x$ (cm) of said inner layer (58) is determined by the following relationship:

$$\Delta x = \sqrt{\frac{\kappa}{\pi R}} \cdot \ln (N)$$

wherein R is the rotational rate of the susceptor (42) about its axis (rps), $\kappa$ is the thermal diffusivity of the inner layer (58) ($cm^2/s$) and N is $\frac{100-A}{100}$ with A being the attenuation percentage of the temperature value variations.

4. Apparatus as claimed in claim 3, wherein said inner layer (58) is silica and $\Delta X = 0.15$ cm such that for susceptor rotation of r equal to 30 rpm, there results 90 percent attentuation of the temperature value variations in the melt (12).

5. Apparatus for growing Czochralski crystals having a central stationary crucible adapted to contain the source of materials for the crystal to be grown,

a heater concentrically surrounding said central crucible and operative to render and maintain the source material in a molten state,

means for introducing a seed crystal into the molten source material and withdrawing it at a controlled rate as the source material crystallizes thereupon axially of said crucible,

and a susceptor concentrically interposed between said heater and said crucible and rotating around the axis of the crucible,

characterized in that means (78, 90) are provided for simultaneously applying a magnetic field to the molten source material (61) in said crucible (8).

6. Apparatus as claimed in claim 5, wherein said magnetic field applying means (78) comprises a DC solenoid electromagnet of cylindrical form concentric about said heater (62).

7. Apparatus as claimed in claim 5, wherein said means (90) for applying a magnetic field to the molten source material (61) in said crucible (8) comprises a U-shaped cylindrical solenoid electromagnet assembly, said solenoid electromagnet assembly comprising a cylindrical iron yoke (94), a cylindrical solenoid electromagnet (92) concentrically surrounding said cylindrical iron yoke (94) and centered longitudinally with respect thereto, magnetic material plates (59) removably fixed at one end to respective ends of said yoke (94) and extending parallel to each other and having their opposite ends terminating on opposite sides of the concentric array of said crucible (8), said susceptor (64) and said heater (62), and magnet poles (96, 98) fixedly attached to the faces of said magnetic material plates (59) proximate to said concentric array.

8. Apparatus as claimed in claim 7, wherein said magnetic poles (96, 98) are of circular geometry and are of a width in excess of the width of said concentric array.

9. Apparatus as claimed in any one of claims 5 to 8, wherein said means for introducing and withdraw-

FI 982 055/056

ing said seed crystal (86) are movable vertically only.

10. Method for growing crystals by applying the Czochralski technique using an apparatus according to any one of claims 5 to 9, where

source material for the crystal is confined within said crucible,

said heater concentrically surrounding said crucible is energized to effect and maintain said source material in a molten state,

said cylindrical susceptor concentrically interposed between said heater and said crucible is rotated and

said seed crystal is introduced into the molten source material and then withdrawn at a controlled rate,

characterized by the application of a magnetic field to the molten source material (61) simultaneously with the rotation of said susceptor (64).

11. Method as claimed in claim 10, wherein said step of applying said magnetic field to the molten source material (61) in the crucible (8) comprises applying an axial magnetic field to the molten source material (61).

12. Method as claimed in claim 10, wherein said step of applying a magnetic field to the molten source material (61) in the crucible comprises the step of applying a transverse magnetic field across said molten source material (61).

13. Method as claimed in any one of claims 10 to 12, wherein the said seed crystal (86) is introduced and withdrawn without rotating.

14. Method as claimed in any one of claims 10 to 13, wherein doped silicon crystals are grown.

FIG.1 (PRIOR ART)

FIG.2 (PRIOR ART)

FIG.3
(PRIOR ART)

GROWTH
DIRECTION

FIG.4

FIG. 5

FIG. 6

982 055 / 56

## FIG.7 PRIOR ART

CRYSTAL PULL DIRECTION    ⊢————⊣ 100 μm

## FIG. 8

FIG.9
PRIOR ART

FIG.10